# EUROPÄISCHE PATENTSCHRIFT

(11) **EP 1 540 725 B1**
(45) Veröffentlichungstag und Bekanntmachung des Hinweises auf die Patenterteilung: **18.06.2008**
(21) Anmeldenummer: 03747835.1
(22) Anmeldetag: 13.09.2003
(51) Int. Cl.: H01L 21/8242, H01L 27/108, H01L 27/12

(54) **VERFAHREN ZUR HERSTELLUNG EINES HALBLEITERBAUTEILS MIT IM SUBSTRAT VERGRABENEN KONDENSATOREN UND DAVON ISOLIERTER BAUELEMENTSCHICHT**
METHOD OF MANUFACTURE OF A SEMI-CONDUCTOR COMPONENT WITH CONDENSATORS BURIED IN THE SUBSTRATE AND INSULATED COMPONENT LAYER THEREOF
PROCÉDÉ DE FABRICATION D'UN COMPOSANT SEMI-CONDUCTEUR POURVU DE CONDENSATEURS ENTERRES DANS LE SUBSTRAT ET D'UNE COUCHE DE COMPOSANT ISOLEE DE CES CONDENSATEURS

(30) Priorität: 16.09.2002 DE 10242877
(43) Veröffentlichungstag der Anmeldung: 15.06.2005
(73) Patentinhaber: Infineon Technologies AG, 81669 München (DE)
(72) Erfinder: HOFMANN, Franz, 80995 München (DE); LEHMANN, Volker, 80689 München (DE); RISCH, Lothar, 85579 Neubiberg (DE); RÖSNER, Wolfgang, 85521 Ottobrunn (DE); SPECHT, Michael, 80799 München (DE)
(74) Vertreter: Kindermann, Peter
(86) Internationale Anmeldenummer: PCT/DE2003/003044
(87) Internationale Veröffentlichungsnummer: WO 2004/027861

(56) Entgegenhaltungen:
- EP-A- 0 553 791
- WO-A-99/25026
- DE-A- 10 055 711
- DE-A- 10 133 688
- US-A- 5 055 898
- US-A- 5 739 565
- US-B1- 6 306 719
- US-B1- 6 441 424
- PATENT ABSTRACTS OF JAPAN vol. 014, no. 187 (E-0917), 16. April 1990 (1990-04-16) -& JP 02 035770 A (MATSUSHITA ELECTRIC IND CO LTD), 6. Februar 1990 (1990-02-06)
- PATENT ABSTRACTS OF JAPAN vol. 012, no. 412 (E-676), 31. Oktober 1988 (1988-10-31) & JP 63 151071 A (MATSUSHITA ELECTRIC IND CO LTD), 23. Juni 1988 (1988-06-23)

## Beschreibung

Die vorliegende Erfindung bezieht sich auf ein Verfahren zur Herstellung eines Halbleitersubstrats sowie eine darin ausgebildete Halbleiterschaltung und insbesondere auf ein SOI-Substrat, in dem eine Vielzahl von vergrabenen Kondensatoren ausgebildet sind.

Bei der unvermindert fortschreitenden Erhöhung der Integrationsdichte von Halbleiterschaltungen und insbesondere einer Speicherdichte von DRAMs (Dynamic Random Access Memories) stößt man mehr und mehr auf Probleme, die notwendige Speicherkapazität auf der kleiner werdenden Zellfläche unterzubringen. Obwohl die technische Verfeinerung sowohl von sogenannten Trench- bzw. Graben- wie auch von Stacked- bzw. Stapel-Kondensatoren schon weit vorgeschritten ist, werden diese Prozesse in den nächsten Generationen an ihre Grenzen stoßen.

Darüber hinaus stellen integrierte Kondensatoren in Logik- und Analog-Halbleiterschaltungen einen erheblichen Zusatzaufwand dar. Dies gilt insbesondere für hochdichte sogenannte "Embedded DRAMs", da das hoch-optimierte und sehr platzsparende Zelldesign von modernen DRAMs einen Herstellprozess erfordert, der nicht mehr leicht mit einem Logik-Prozess kombiniert werden kann.

Insbesondere die Speicherkondensatoren in DRAMs haben eine langjährige Evolution hinter sich mit dem Ziel, die Kapazität trotz der immer geringer werdenden Zellfläche bei ca. 30 fF nahezu konstant zu halten. Zur Realisierung derartiger Kondensatoren werden hierbei zwei unterschiedliche Ausführungsformen unterschieden. Erstens der "stacked capacitor" bzw. Stapelkondensator, der nach Fertigstellung eines Auswahltransistors hergestellt und über ein eigenes Kontaktloch mit dem Transistor verbunden wird, wobei sich eine Oberflächenvergrößerung der Speicherelektrode beispielsweise durch eine zylindrische Ausgestaltung ergibt. Als zweite Ausführungsform ist der "trench capacitor" bzw. Grabenkondensator bekannt, wobei vor dem Ausbilden des Auswahltransistors ein Loch mit sehr hohem Aspektverhältnis (Tiefe:Durchmesser) in ein Halbleitersubstrat geätzt und der Kondensator darin hergestellt wird. In beiden Varianten kann zur weiteren Kapazitätsvergrößerung die Oberfläche der Elektrode durch halbkugelförmige Halbleiterturner (Hemispherical Grains, HFG) aufgeraut werden. Trotz dieser technologischen Anstrengungen wird man mit den weiterentwickelten herkömmlichen Kondensatoren in absehbarer Zeit nicht mehr die erforderliche Kapazität erreichen können.

Ferner ist aus der Druckschrift EP 0 921 572 A1 ein Verfahren zur Herstellung von Kondensatoren für eine DRAM-Zelle bekannt, wobei in einem ersten Halbleitersubstrat eine Halbleiterschaltung und in einem zweiten Si-Substrat mittels elektrochemischen Porenätzens eine Vielzahl von Kondensatoren ausgebildet werden. Die beiden so vorbereiteten Substrate werden anschließend derart miteinander in Kontakt gebracht, dass die Kontaktflächen der Halbleiterschaltung eine vorbestimmte Anzahl von Kondensatoren berühren, wodurch sich für die Schaltung vorbestimmte Gesamt-Kondensatoren ergeben. Nachteilig sind hierbei jedoch erhöhte Schwierigkeiten bei der Kontaktierung der fertigen Halbleiterschaltung sowie kontaktflächenabhängige Kapazitäten.

Ein weiteres Herstellungsverfahren ist in dem Dokument US5055898 beschrieben.

Die beanspruchte Erfindung liegt daher die Aufgabe zugrunde, ein Verfahren zur Herstellung eines Halbleitersubstrats sowie eine darin ausgebildete Halbleiterschaltung zu schaffen, wobei auf besonders einfache und kostengünstige Art und Weise große Kapazitäten realisierbar sind.

Hinsichtlich des Halbleitersubstrats wird diese Aufgabe insbesondere durch ein Trägersubstrat und einer Halbleiter-Bauelementschicht mit einer dazwischenliegenden Isolationsschicht gelöst, wobei im Trägersubstrat eine Vielzahl von Vertiefungen mit einer dielektrischen Schicht und einer elektrisch leitenden Schicht zur Realisierung einer Vielzahl von Kondensatoren ausgebildet ist. Bei Verwendung eines derartigen Halbleitersubstrats kann weiterhin eine einfache Kontaktierung einer darin ausgebildeten Halbleiterschaltung durchgeführt werden, wobei ferner Kondensatoren mit erhöhter Kapazität zur Verfügung stehen.

Vorzugsweise wird die zur Ausbildung der Vielzahl von Kondensator-Elektroden verwendete elektrisch leitende Schicht auch an der Oberfläche des Trägersubstrats ausgebildet, wodurch eine Vielzahl von Einzel-Kondensatoren gruppenmäßig zusammengefasst werden können und fest vorgegebene Kapazitäten realisierbar sind. Bei einer entsprechenden Strukturierung dieser elektrisch leitenden Schicht zur Realisierung eines Gruppen-Kondensators mit einer Kapazität von ca. 30 fF können insbesondere die im DRAM notwendigen Speicherkondensatoren bereits vorgefertigt im Halbleitersubstrat vorliegen.

Vorzugsweise erfolgt das Ausbilden der Vertiefungen für die Kondensatoren durch elektrochemisches Porenätzen, wodurch man ein feinverästeltes Porensystem mit außerordentlich großer Oberfläche erhält und ferner Kurzschlüsse bzw. Querverbindungen innerhalb der Poren automatisch verhindert werden.

Vorzugsweise wird für die in den Poren ausgebildete dielektrische Schicht ein hochtemperaturfestes Kondensatordielektrikum mit hoher Dielektrizitätskonstante verwendet, wodurch man einerseits erhöhte Kapazitäten und andererseits eine verbesserte Unempfindlichkeit für die nachfolgenden Prozessschritte bei der Realisierung einer Halbleiterschaltung in der Halbleiter-Bauelementschicht erhält.

Vorzugsweise basiert das Halbleitersubstrat auf einem SOI-Substrat mit einer einkristallinen Si-Schicht als Bauelementschicht, einer SiO₂-Schicht als Isolationsschicht und einem Si-Substrat als Trägersubstrat, weshalb bereits bekannte Herstellungsverfahren kostengünstig modifizierbar sind und weiterhin im Einsatz befindliche Standardprozesse und Fertigungsvorrichtungen verwendet werden können.

Hinsichtlich des Verfahrens zur Herstellung eines Halbleitersubstrats wird zunächst eine Vielzahl von Vertiefungen sowie eine Kondensator-Gegenelektrode in einem Trägersubstrat ausgebildet und anschließend eine dielektrische Schicht an der Oberfläche der Vertiefungen sowie des Trägersubstrats hergestellt. Daraufhin wird eine elektrisch leitende Schicht zur Realisierung einer Vielzahl von Kondensator-Elektroden zumindest in der Vielzahl von Vertiefungen ausgebildet und eine erste Isolations-Teilschicht ganzflächig erzeugt. Ferner wird ein Halbleiter-Bauelementsubstrat mit einer darin ausgebildeten Abspalt-Grenzschicht und einer zweiten Isolations-Teilschicht bereitgestellt und mit dem Trägersubstrat über die jeweiligen Isolations-Teilschichten miteinander verbunden. Abschließend erfolgt ein Abspalten eines Teils des Halbleiter-Bauelementsubstrats an der Abspalt-Grenzschicht, wodurch man das endgültige Halbleitersubstrat mit der im Trägersubstrat ausgebildeten Vielzahl von Kondensatoren auf besonders einfache und kostengünstige Art und Weise erhält.

Vorzugsweise wird das Ausbilden der Vertiefungen durch ein elektrochemisches Porenätzen zum Ausbilden von Poren in einem aus Halbleitermaterial bestehenden Trägersubstrat und das Ausbilden der Kondensator-Gegenelektrode durch ein Dotieren des Trägersubstrats in der Umgebung der Poren realisiert.

Als Kondensatordielektrikum wird vorzugsweise nitridiertes Oxid, Al₂O₃ und/oder TiO₂ verwendet, wodurch man sowohl eine hohe Temperaturfestigkeit als auch eine hohe Dielektrizitätskonstante erhält.

Als elektrisch leitende Schicht zur Realisierung der Kondensator-Elektroden wird vorzugsweise ein in-situ dotiertes Halbleitermaterial abgeschieden und derart strukturiert, dass eine Vielzahl von Einzel-Kondensatoren zu einem Gruppen-Kondensator zusammengefasst werden können.

Hinsichtlich der Halbleiterschaltung wird in dem Halbleitersubstrat als Halbleiterbauelement vorzugsweise eine DRAM-Speicherzelle ausgebildet, wobei eine Kontaktierung der im Trägersubstrat befindlichen Kondensatoren über ein mit einer Verbindungsschicht gefülltes Kontaktloch erfolgt, welches in der Isolationsschicht des Halbleitersubstrats ausgebildet ist.

In den weiteren Ansprüchen sind weitere vorteilhafte Ausgestaltungen der Erfindung gekennzeichnet.

Die Erfindung wird nachstehend an Hand von Ausführungsbeispielen unter Bezugnahme auf die Zeichnung näher beschrieben.

Es zeigen:
- Figuren 1A bis 1D: vereinfachte Schnittansichten zur Veranschaulichung wesentlicher Herstellungsschritte bei der Herstellung eines Halbleitersubstrats gemäß einem ersten Ausführungsbeispiel;
- Figuren 2A und 2B: vereinfachte Schnittansichten zur Veranschaulichung eines Halbleitersubstrats gemäß einem zweiten Ausführungsbeispiel sowie eines zugehörigen Verfahrensschrittes zur Herstellung von Kontaktlöchern; und
- Figuren 3A bis 3C: vereinfachte Schnittansichten zur Veranschaulichung eines Herstellungsverfahrens einer DRAM-Speicherzelle.

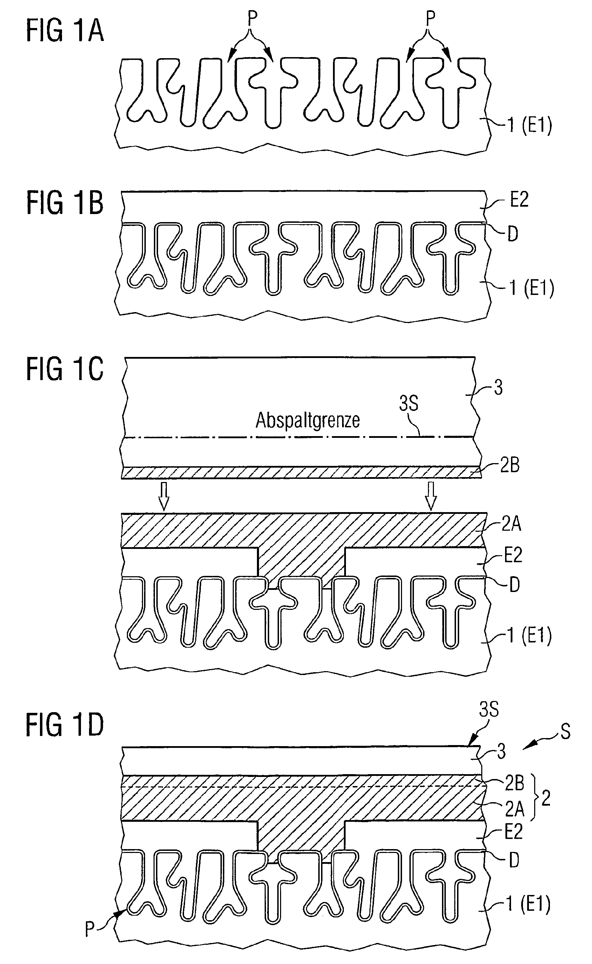

Figuren 1A bis 1C zeigen vereinfachte Schnittansichten zur Veranschaulichung wesentlicher Verfahrensschritte bei der Herstellung eines Halbleitersubstrats gemäß einem ersten bevorzugten Ausführungsbeispiels.

Gemäß Figur 1A wird in einem Trägersubstrat 1, welches beispielsweise ein Halbleitersubstrat und vorzugsweise einen Silizium-Halbleiterwafer darstellt, eine Vielzahl von Vertiefungen P sowie eine Kondensator-Gegenelektrode E1 ausgebildet. Vorzugsweise wird mittels eines elektrochemischen Porenätzverfahrens eine Vielzahl von Poren P als Vertiefungen im Trägersubstrat 1 ausgebildet, welches z.B. n-dotiertes Silizium aufweist. Das Trägersubstrat besitzt beispielsweise eine Dotierstoffkonzentration von ca. 10¹⁸ cm⁻³ und wird zunächst mit einem ersten Spannungsanschluss verbunden und in eine Flusssäurelösung (25 Gew.-%) eingetaucht. In der Flusssäurelösung befindet sich eine Elektrode, die mit einem zweiten Spannungsanschluss verbunden ist. Anschließend wird eine Spannung zwischen dem ersten Spannungsanschluss und dem zweiten Spannungsanschluss erzeugt, die ca. 2 Volt beträgt. Die Spannungsdifferenz zwischen dem ersten und zweiten Spannungsanschluss ist hierbei positiv, wobei eine entstehende Stromdichte ca. 100 mA/cm² beträgt. Bei diesem elektrochemischen Porenätzverfahren entstehen nach einigen Minuten ca. 100 nm breite und einige Mikrometer tiefe Poren P im Trägersubstrat 1, wobei die Abstände zwischen benachbarten Poren P etwa gleich groß sind, ca. 20 nm betragen und die Poren räumlich nicht regelmäßig angeordnet sind.

Zur Erzeugung der Kondensator-Gegenelektrode E1 im Trägersubstrat 1 wird beispielsweise in der Umgebung der Poren P eine Dotierung des Halbleitermaterials durchgeführt. Vorzugsweise wird zur Ausbildung einer hochdotierten und somit elektrisch leitenden Schicht ein Dotierglas in den Poren P ausgebildet und nachfolgend durch eine thermische Behandlung in das Trägersubstrat 1 ausdiffundiert. Abschließend erfolgt eine vorzugsweise nass-chemische Entfernung des Dotierglases, wodurch man die in Figur 1A dargestellte Schnittansicht erhält. Vorzugsweise wird als Dotierstoffquelle Phosphorsilikatglas mit einer Dicke von einigen Nanometern in den Poren P abgeschieden, wodurch man eine n⁺-Dotierung an der gesamten Oberfläche im Bereich der Poren P im Trägersubstrat 1 erhält. Alternativ kann selbstverständlich auch eine Dotierung aus der Gasphase insbesondere bei geringen Drücken erfolgen, wie sie beispielsweise bei der Herstellung von Grabenkondensatoren bekannt ist. Als Ätzmittel zum Entfernen des Dotierglases wird vorzugsweise Flusssäure verwendet, wobei auch andere Ätzmittel verwendet werden können.

Die durch das elektrochemische Porenätzen ausgebildeten Poren P können demzufolge ohne gezielte Keim-Bildung in einer zufälligen Anordnung erzeugt sein, wobei ihre Dichte, ihr mittlerer Durchmesser, die Dicke der Trennwände und die Länge durch die Parameter des Verfahrens, wie z.B. Halbleiter-Dotierung, Konzentration des Ätzmittels, Stromstärke, Spannung und Ätzdauer über einen weiten Bereich eingestellt werden kann.

Gemäß Figur 1B wird anschließend an der Oberfläche der Vertiefungen P sowie des Trägersubstrats 1 eine dielektrische Schicht D ausgebildet, wobei vorzugsweise nitridiertes Oxid, Al₂O₃ und/oder TiO₂ als Kondensatordielektrikum ganzflächig ausgebildet wird. Demzufolge kann zur Ausbildung eines nitridierten Oxids zunächst eine thermische Oxidation des Trägersubstrats 1 und eine anschließende Nitridierung durchgeführt werden. Alternativ kann zur Realisierung der weiterhin möglichen Kondensatordielektrika Al₂O₃ und/oder TiO₂ eine Abscheidung entsprechender Materialien durchgeführt werden. Insbesondere bei Verwendung von hochtemperaturfesten Kondensatordielektrika, die darüber hinaus eine hohe Dielektrizitätskonstante aufweisen, erhält man somit ein Halbleitersubstrat, welches für eine Vielzahl von Standardprozessen, d.h. auch Hochtemperaturprozessen, geeignet ist und darüber hinaus Kondensatoren mit hoher Kapazität realisiert.

Nach dem ganzflächigen Ausbilden dieser dielektrischen Schicht D in den Poren P sowie an der Oberfläche des Trägersubstrats 1 wird anschließend eine elektrisch leitende Schicht E2 zur Realisierung einer Vielzahl von Kondensator-Elektroden zumindest in der Vielzahl von Vertiefungen P auf der dielektrischen Schicht D ausgebildet.

Zur Realisierung der dielektrischen Schicht D und/oder der elektrisch leitenden Schicht E2 kann insbesondere ein sogenanntes ALD-Verfahren (Atomic Layer Deposition) zum Ausbilden von Schichten in der Größenordnung einzelner Atomlagen verwendet werden.

Gemäß Figur 1B wird beispielsweise ein in-situ dotiertes polykristallines Halbleitermaterial und vorzugsweise in-situ dotiertes Polysilizium ganzflächig abgeschieden, wodurch nicht nur die Poren P vollständig aufgefüllt werden, sondern darüber hinaus eine alle Poren bedeckende Schicht an der Oberfläche des Trägersubstrats 1 ausgebildet wird. Zur Strukturierung dieser elektrisch leitenden Schicht E2 wird vorzugsweise ein fotolithografisches Verfahren durchgeführt, wobei mittels herkömmlicher Fotolacke, nachfolgender Belichtung und abschließender Ätzung die elektrisch leitende Schicht E2 derart strukturiert wird, dass eine Vielzahl von im Trägersubstrat 1 ausgebildeten Einzel-Kondensatoren (bzw. Kondensator-Elektroden) oder Gruppen-Kondensatoren entstehen, wobei gemäß Figur 1C eine vorbestimmte Anzahl von Einzel-Kondensatoren (bzw. Kondensator-Elektroden) zu einer Gruppe zusammengefasst werden und einen Gruppen-Kondensator mit vorbestimmter Kapazität realisieren. Insbesondere bei der Realisierung von Halbleitersubstraten für sogenannte DRAM-Speichereinrichtungen kann eine derartige Strukturierung derart eingestellt werden, dass sich jeweils Gruppen-Kondensatoren mit einer gewünschten Kapazität von ca. 30 fF ergeben, wie sie üblicherweise in DRAM-Zellen notwendig sind.

Eine derartige Strukturierung erfolgt vorzugsweise mittels anisotroper Rückätzverfahren, wie beispielsweise RIE (Reactive Ion Etching). Zur Vermeidung eines Kurzschlusses zwischen der äußeren Kondensator-Gegenelektrode E1 und der inneren bzw. Kondensator-Elektrode E2 wird die dielektrische Schicht D vorzugsweise nicht entfernt.

Gemäß Figur 1C wird anschließend an dieser bearbeiteten Oberfläche des Trägersubstrats 1 eine erste Isolations-Teilschicht 2A ganzflächig ausgebildet, wobei vorzugsweise ein TEOS-Abscheideverfahren (Tetra Ethyl Ortho Silicat) durchgeführt wird. Zur Realisierung einer planaren Oberfläche kann nach dem Ausbilden der Isolations-Teilschicht 2A und insbesondere nach dem Abscheiden einer TEOS-Schicht vorzugsweise ein CMP-Verfahren (Chemical Mechanical Polishing) durchgeführt werden.

Gemäß Figur 1C wird ferner ein weiteres Halbleiter-Bauelementsubstrat 3 mit einer Abspalt-Grenzschicht 3S und einer zweiten Isolations-Teilschicht 2B bereitgestellt, wobei vorzugsweise wiederum ein Siliziumhalbleiterwafer mit einer Siliziumdioxidschicht 2B bereitgestellt und die Abspalt-Grenzschicht mittels Wasserstoff-Implantation ausgebildet wird.

Anschließend werden diese beiden Substrate an bzw. über ihre Isolations-Teilschichten 2A und 2B zum Ausbilden einer gemeinsamen Isolationsschicht 2 miteinander verbunden, wobei vorzugsweise herkömmliches Waferbonden durchgeführt wird. Genauer gesagt wird insbesondere bei Verwendung von Siliziumdioxid als Isolations-Teilschichten 2A und 2B aufgrund ihrer hydrophilen Eigenschaften eine Anziehungskraft auf die beiden Substrate an der Verbindungsoberfläche ausgeübt, wobei durch eine zusätzliche thermische Behandlung eine mechanisch sehr feste Verbindung realisiert wird und auf die Verwendung zusätzlicher Verbindungs- bzw. Klebematerialien verzichtet werden kann.

Gemäß Figur 1D wird abschließend ein (oberer) Teil des Halbleiter-Bauelementsubstrats 3 an der Abspalt-Grenzschicht 3S abgespalten, wodurch man das fertige Halbleitersubstrat S mit einer Vielzahl von eingegrabenen Kondensatoren erhält. Vorzugsweise erfolgt dieser Abspaltvorgang durch eine weitere thermische Behandlung, wobei im Falle der vorstehend beschriebenen Wasserstoff-Implantation der obere Teil des Wafers entlang der implantierten Abspalt-Grenzschicht abplatzt bzw. abgespalten wird. Alternativ zu diesem als "smart cut"-Verfahren bekannten Abspaltvorgang können auch weitere Verfahren wie z.B. das sogenannte "ELTRAN"-Verfahren durchgeführt werden, wobei als Abspalt-Grenzschicht 3S eine poröse Halbleiterschicht verwendet wird und mittels eines Flüssigkeitsstrahls ein Abheben des oberen Teils des Halbleiter-Bauelementsubstrats 3 durchgeführt werden kann.

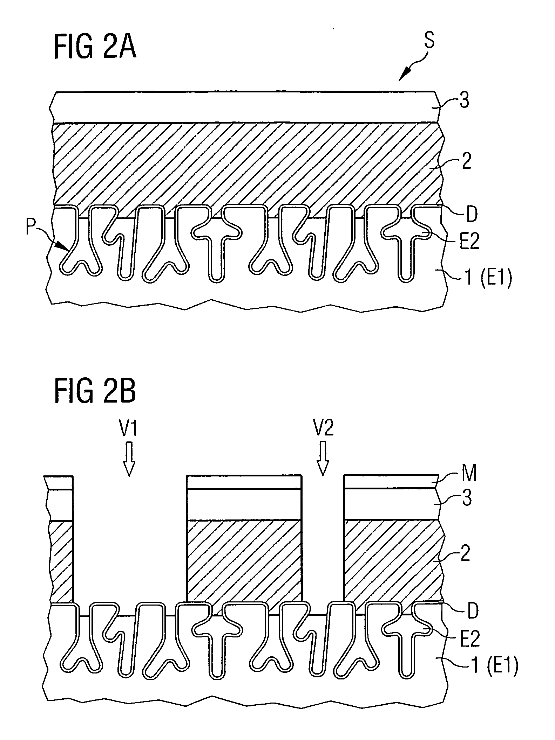

Figur 2A und Figur 2B zeigen vereinfachte Schnittansichten zur Veranschaulichung eines Halbleitersubstrats gemäß einem zweiten Ausführungsbeispiel sowie eines Verfahrensschrittes zur Realisierung von Kondensatoren mit unterschiedlichen Kapazitäten, wobei gleiche Bezugszeichen gleiche oder entsprechende Schichten bzw. Elemente bezeichnen und auf eine wiederholte Beschreibung nachfolgend verzichtet wird.

Gemäß Figur 2A kann eine Strukturierung der elektrisch leitenden Schicht E2 auch derart erfolgen, dass keine Gruppierung von Einzel-Kondensatoren erfolgt, wie in Figur 1C dargestellt, sondern die an der Oberfläche des Trägersubstrats abgeschiedene elektrisch leitende Schicht E2 vollständig bis an die Oberfläche des Trägersubstrats 1 bzw. die dielektrische Schicht D zurückgeätzt wird oder die elektrisch leitende Schicht E2 lediglich bis zur Oberfläche der Poren P aufgefüllt wird. Auf diese Weise erhält man keine elektrisch leitende Verbindung der einzelnen Kondensatoren bzw. Kondensator-Elektroden E2, weshalb eine Definition der Kondensatorkapazität ausschließlich über die Größe eines Kontaktloches erfolgen kann.

Gemäß Figur 2B können demzufolge mittels einer Maskenschicht M unterschiedlich große Kontaktlöcher V1 und V2 ausgebildet werden, die eine unterschiedliche Anzahl von Einzel-Kondensatoren bzw. Anzahl von Kondensator-Elektroden E2 freilegen, wodurch eine feingranulare Einstellung einer Kapazität auch in einem späteren Herstellungsprozess zur Realisierung einer jeweiligen Halbleiterschaltung realisiert werden kann.

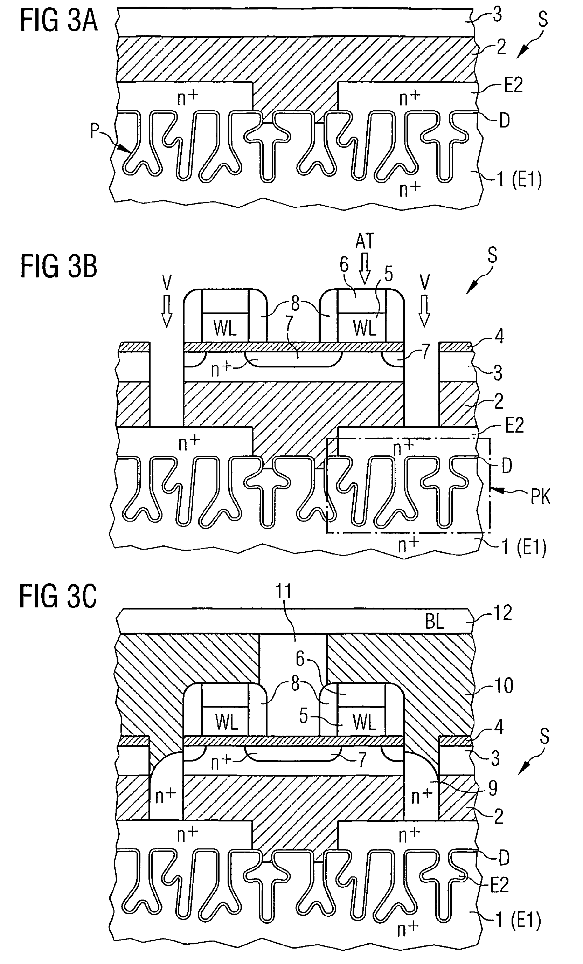

Figuren 3A bis 3C zeigen vereinfachte Schnittansichten zur Veranschaulichung wesentlicher Verfahrensschritte bei der Herstellung einer Halbleiterschaltung in einem Halbleitersubstrat gemäß dem ersten Ausführungsbeispiel, wobei gleiche Bezugszeichen wiederum gleiche Schichten bzw. Elemente bezeichnen und auf eine wiederholte Beschreibung nachfolgend verzichtet wird.

Gemäß Figur 3A wird zur Realisierung einer DRAM-Speicherzelle mit einem Auswahltransistor und einem Porenkondensator PK (d.h. in einer Gruppe zusammengefassten Anzahl von vergrabenen Einzel-Kondensatoren) zunächst eine (nicht dargestellte) flache Grabenisolierung in der Halbleiter-Bauelementschicht 3 zur Realisierung von aktiven Gebieten ausgebildet.

Anschließend wird gemäß Figur 3B beispielsweise ein herkömmlicher Prozesskomplex für MOS-Transistoren zur Realisierung eines Auswahltransistors AT als auszubildendes Halbleiterbauelement mit Source-/Draingebieten 7, einem Gatedielektrikum bzw. einer Gateoxidschicht 4, einer Steuerschicht 5 bzw. Wortleitung WL und einer Gateisolation bzw. -Kapselung, die beispielsweise eine Nitrid-Abdeckschicht 6 und Nitrid-Spacer 8 aufweist, durchgeführt. Hinsichtlich der einzelnen Verfahrensschritte wird hierbei explizit auf die bekannten Standard MOS-Verfahren verwiesen.

Anschließend wird zur Realisierung eines Anschlussbereiches zum vergrabenen Kondensator bzw. zur Kondensator-Elektrode E2 ein Kontaktloch V zumindest in der Isolationsschicht 2 und der Halbleiter-Bauelementschicht 3 ausgebildet, wobei bei Vorliegen der Gateoxidschicht bzw. des Gatedielektrikums 4 auch diese Schicht lokal entfernt werden kann.

Gemäß Figur 3B wird dieses Kontaktloch V unmittelbar an den Seitenwänden der Spacer 8 der Auswahltransistoren AT ausgebildet, wodurch ein jeweiliges Source-/Draingebiet 7 sowie eine zugehörige Kondensator-Elektrode E2 freigelegt wird. Demzufolge kann ein relativ ungenaues fotolithografisches Verfahren zur Realisierung der Kontaktlöcher V verwendet werden, wobei lediglich eine Überlappung der Lithografie-Öffnungen mit der Auswahltransistorkapselung bzw. den Spacern 8 und der Abdeckschicht 6 sichergestellt werden muss. Demzufolge können die Kontaktlöcher V selbstjustierend ausgebildet werden.

Vorzugsweise wird zum Entfernen der Isolationsschicht 2 der Halbleiter-Bauelementschicht 3 und gegebenenfalls des Gatedielektrikums 4 im Bereich des Kontaktloches V ein anisotropes Ätzverfahren und insbesondere ein reaktives Ionenätzen (RIE) durchgeführt.

Gemäß Figur 3C wird anschließend eine Verbindungsschicht 9 im Kontaktloch V zwischen Halbleiterbauelement bzw. dem Source-/Draingebiet 7 des Auswahltransistors AT und zumindest einer Kondensator-Elektrode E2 ausgebildet. Vorzugsweise wird zum Ausbilden dieser Verbindungsschicht 9 eine weitere in-situ dotierte polykristalline Halbleiterschicht und insbesondere polykristallines Silizium ganzflächig abgeschieden und anschließend isotrop oder anisotrop bis in das Kontaktloch V zurückgeätzt.

Zur Fertigstellung der DRAM-Speicherzelle wird abschließend eine Zwischen-Isolationsschicht 10 mit einem Bitleitungskontakt 11 ausgebildet, die ein jeweiliges komplementäres Source-/Draingebiet 7 des Auswahltransistors AT kontaktiert. Zur Realisierung einer Bitleitung BL wird schließlich an der Oberfläche der Zwischen-Isolationsschicht 10 in üblicher Weise noch eine elektrisch leitende Bitleitungsschicht 12 ausgebildet und strukturiert, wodurch man die in Figur 3C dargestellte endgültige Schnittansicht einer DRAM-Speicherzelle erhält.

Die Erfindung wurde vorstehend an Hand eines SOI-Substrats mit einem Si-Trägersubstrat, einer SiO₂-Isolationsschicht und einer einkristallinen Si-Halbleiter-Bauelementschicht beschrieben, wobei als elektrisch leitende Schicht polykristallines Silizium und als dielektrische Schicht nitridiertes Oxid verwendet wird. In gleicher Weise können selbstverständlich auch alternative Materialien und entsprechende Schichten zur Realisierung des erfindungsgemäßen Halbleitersubstrats und der zugehörigen Halbleiterschaltung verwendet werden. Insbesondere kann als Trägersubstrat auch ein elektrisch leitendes oder elektrisch isolierendes Substrat mit integrierter Kondensator-Gegenelektrode verwendet werden. In gleicher Weise können neben den dargestellten Dotierungen auch die jeweils entgegengesetzten Dotierungen verwendet werden. Insbesondere für die elektrisch leitende Schicht können auch metallische Materialien zur Realisierung der Kondensator-Gegenelektroden verwendet werden.

Ferner ist die beanspruchte Erfindung nicht auf die dargestellte DRAM-Zelle beschränkt, sondern umfasst in gleicher Weise jegliche Halbleiterbauelemente, die in einem Halbleitersubstrat ausgebildet sind und über ein Kontaktloch sowie einer darin befindlichen Verbindungsschicht einen vergrabenen Kondensator Kontaktieren.

## Patentansprüche

1. Verfahren zur Herstellung eines Halbleitersubstrats mit den Schritten:
a) Ausbilden einer Vielzahl von Vertiefungen (P) und einer Kondensator-Gegenelektrode (E1) in einem Trägersubstrat (1);
b) Ausbilden einer dielektrischen Schicht (D) an der Oberfläche der Vertiefungen (P) sowie des Trägersubstrats (1);
c) Ausbilden und Strukturieren einer elektrisch leitenden Schicht (E2) auf der dielektrischen Schicht (D) zur Realisierung einer Vielzahl von Kondensator-Elektroden zumindest in der Vielzahl von Vertiefungen (P);
d) Ausbilden einer ersten Isolations-Teilschicht (2A) an der bearbeiteten Oberfläche des Trägersubstrats (1);
e) Bereitstellen eines Halbleiter-Bauelementsubstrats (3) mit einer Abspalt-Grenzschicht (3S) und einer zweiten Isolations-Teilschicht (2B);
f) Verbinden des Halbleiter-Bauelementsubstrats (3) und des Trägersubstrats (1) an ihren Isolations-Teilschichten (2A, 2B) zum Ausbilden einer Isolationsschicht (2); und
g) Abspalten eines Teils des Halbleiter-Bauelementsubstrats (3) an der Abspalt-Grenzschicht (3S).

2. Verfahren nach Patentanspruch 1, **dadurch gekennzeichnet, dass** in Schritt a)
a1) ein elektrochemisches Porenätzen zum Ausbilden von Poren (P) als Vertiefungen in einem Halbleitersubstrat (1); und
a2) ein Dotieren des Halbleitersubstrats (1) in der Umgebung der Poren (P) zum Ausbilden einer weiteren elektrisch leitenden Schicht als Kondensator-Gegenelektrode (E1) durchgeführt wird.

3. Verfahren nach Patentanspruch 2, **dadurch gekennzeichnet, dass** in Schritt a2)
a21) ein Ausbilden eines Dotierglases zumindest in den Poren (P) ;
a22) eine thermische Behandlung; und
a23) eine nass-chemische Entfernung des Dotierglases durchgeführt wird.

4. Verfahren nach einem der Patentansprüche 1 bis 3, **dadurch gekennzeichnet, dass** in Schritt b) ein hochtemperaturfestes Kondensatordielektrikum mit hoher Dielektrizitätskonstante ganzflächig ausgebildet wird.

5. Verfahren nach Patentanspruch 4, **dadurch gekennzeichnet, dass** nitridiertes Oxid, Al₂O₃ und/oder TiO₂ als Kondensatordielektrikum ausgebildet wird.

6. Verfahren nach einem der Patentansprüche 1 bis 5, **dadurch gekennzeichnet, dass** in Schritt c)
c1) eine elektrisch leitende Schicht (E2) zum Auffüllen der Vertiefungen (P) ganzflächig ausgebildet wird; und
c2) die elektrisch leitende Schicht (E2) zumindest teilweise oder vollständig bis zur dielektrischen Schicht (D) an der Oberfläche des Trägersubstrats (1) entfernt wird.

7. Verfahren nach Patentanspruch 6, **dadurch gekennzeichnet, dass** in Schritt c1)
in-situ dotiertes Polysilizium abgeschieden wird; und in Schritt c2)
ein fotolithografisches Strukturieren mit einem anisotropen Rückätzen derart durchgeführt wird, dass eine Vielzahl von Kondensator-Elektroden zur Realisierung eines Gruppen-Kondensators (PK) miteinander verbunden sind.

8. Verfahren nach einem der Patentansprüche 1 bis 7, **dadurch gekennzeichnet, dass** in Schritt d)
ein TEOS-Abscheideverfahren durchgeführt wird.

9. Verfahren nach einem der Patentansprüche 1 bis 8, **dadurch gekennzeichnet, dass** in Schritt e)
ein Halbleiterwafer (3) mit einer Oxidschicht (2B) bereitgestellt wird, wobei die Abspalt-Grenzschicht (35) mittels Wasserstoff-Implantation ausgebildet ist.

10. Verfahren nach einem der Patentansprüche 1 bis 9, **dadurch gekennzeichnet, dass** in Schritt f) zum Verbinden ein Waferbonden durchgeführt wird.

11. Verfahren nach einem der Patentansprüche 1 bis 10, **dadurch gekennzeichnet, dass** in Schritt g)
zum Abspalten eine weitere thermische Behandlung durchgeführt wird.

12. Verfahren zur Herstellung einer DRAM-Speicherzelle in einem gemäß der Patentansprüche 1 bis 11 hergestellten Halbleitersubstrat mit den Schritten:
a) Ausbilden einer flachen Grabenisolierung in der Halbleiter-Bauelementschicht (3) zur Realisierung von aktiven Gebieten;
b) Ausbilden eines Auswahltransistors (AT) mit Source-/Draingebieten (7), einem Gatedielektrikum (4), einer als Wortleitung (WL) dienenden Steuerschicht (5) und einer Gateisolation (6, 8);
c) Ausbilden eines Kontaktloches (V) zumindest in der Isolationsschicht (2) und der Halbleiter-Bauelementschicht (3);
d) Ausbilden einer Verbindungsschicht (9) im Kontaktloch (V) zwischen einem Source-/Draingebiet (7) des Auswahltransistors (AT) und zumindest einer Kondensator-Elektrode (E2);
e) Ausbilden einer Zwischen-Isolationsschicht (10) mit einem Bitleitungskontakt (11) zu einem komplementären Source-/Draingebiet (7); und
f) Ausbilden und Strukturieren einer Bitleitungsschicht (12) zur Realisierung einer Bitleitung (BL) an der Oberfläche der Zwischen-Isolationsschicht (10).

13. Verfahren nach Patentanspruch 12, **dadurch gekennzeichnet, dass** in Schritt c)
unter Verwendung der Gateisolation (6, 8) und eines lithografischen Verfahrens das Kontaktloch (V) selbstjustierend freigeätzt wird.

14. Verfahren nach Patentanspruch 12 oder 13, **dadurch gekennzeichnet,dass** in Schritt d)
zum Ausbilden der Verbindungsschicht (9) eine weitere in-situ dotierte polykristalline Halbleiterschicht ganzflächig abgeschieden und anschließend isotrop oder anisotrop rückgeätzt wird.

## Claims

1. A method for fabricating a semiconductor substrate having the following steps:
a) formation of a multiplicity of depressions (P) and a capacitor counterelectrode (E1) in a carrier substrate (1);
b) formation of a dielectric layer (D) at the surface of the depressions (P) and of the carrier substrate (1);
c) formation and patterning of an electrically conductive layer (E2) on the dielectric layer (D) for realizing a multiplicity of capacitor electrodes at least in the multiplicity of depressions (P);
d) formation of a first insulation partial layer (2A) at the processed surface of the carrier substrate (1);
e) provision of a semiconductor component substrate (3) with a splitting-off boundary layer (3S), and a second insulation partial layer (2B);
f) connection of the semiconductor component substrate (3) and the carrier substrate (1) at their insulating partial layers (2A, 2B) to form an insulation layer (2); and
g) splitting off part of the semiconductor component substrate (3) at the splitting-off boundary layer (3S).

2. The method as claimed in patent claim 1, **characterized in that**, in step a),
a1) an electrochemical pore etching is carried out for forming pores (P) as depressions in a semiconductor substrate (1); and
a2) a doping of the semiconductor substrate (1) is carried out in the vicinity of the pores (P) for forming a further electrically conductive layer as capacitor counterelectrode (E1).

3. The method as claimed in patent claim 2, **characterized in that**, in step a2),
a21) a formation of a doping glass is carried out at least in the pores (P);
a22) a thermal treatment is carried out; and
a23) a wet-chemical removal of the doping glass is carried out.

4. The method as claimed in one of patent claims 1 to 3, **characterized in that,** in step b), a high-temperature-resistant capacitor dielectric with a high dielectric constant is formed over the whole area.

5. The method as claimed in patent claim 4, **characterized in that** nitrided oxide, Al₂O₃ and/or TiO₂ is formed as the capacitor dielectric.

6. The method as claimed in one of patent claims 1 to **5, characterized in that**, in step c),
c1) an electrically conductive layer (E2) is formed for filling the depressions (P) over the whole area; and
c2) the electronically conductive layer (E2) is at least partially or completely removed as far as the dielectric layer (D) at the surface of the carrier substrate (1).

7. The method as claimed in patent claim 6, **characterized in that**, in step c1),
in-situ-doped polysilicon is deposited; and
in step c2),
photolithographic patterning with an isotropic etching-back is carried out in such a way that a multiplicity of capacitor electrodes are connected to one another for realizing a group capacitor (PK).

8. The method as claimed in one of patent claims 1 to 7, **characterized in that,** in step d),
a TEOS deposition method is carried out.

9. The method as claimed in one of patent claims 1 to 8, **characterized in that**, in step e),
a semiconductor wafer (3) with an oxide layer (2B) is provided, the splitting-off boundary layer (3S) being formed by means of hydrogen implantation.

10. The method as claimed in one of patent claims 1 to 9, **characterized in that**, in step f),
the connection is carried out by means of wafer bonding.

11. The method as claimed in one of patent claims 1 to 10, **characterized in that,** in step g),
the splitting off is carried out by means of a further thermal treatment.

12. A method for fabricating a DRAM memory cell in a semiconductor substrate fabricated as claimed in patent claims 1 to 11, having the following steps:
a) formation of a shallow trench isolation in the semiconductor component layer (3) for realizing active regions;
b) formation of a selection transistor (AT) having source/drain regions (7), a gate dielectric (4), a control layer (5) serving as wordline (WL), and a gate insulation (6, 8);
c) formation of a contact hole (V) at least in the insulation layer (2) and the semiconductor component layer (3);
d) formation of a connecting layer (9) in the contact hole (V) between a source/drain region (7) of the selection transistor (AT) and at least one capacitor electrode (E2);
e) formation of an intermediate insulation layer (10) with a bitline contact (11) to a complementary source/drain region (7); and
f) formation and patterning of a bitline layer (12) for realizing a bitline (BL) at the surface of the intermediate insulation layer (10).

13. The method as claimed in patent claim 12, **characterized in that,** in step c),
the contact hole (V) is etched free in a self-aligning manner using the gate insulation (6, 8) and a lithographic method.

14. The method as claimed in patent claim 12 or 13, **characterized in that**, in step d),
in order to form the connecting layer (9), a further in-situ-doped polycrystalline semiconductor layer is deposited over the whole area and subsequently etched back isotropically or anisotropically.

## Revendications

1. Procédé de production d'un substrat semi-conducteur, dans lequel :
a) on forme une pluralité de cavités (P) et une contre-électrode (E1) de condensateur dans un substrat (1) servant de support ;
b) on forme une couche (D) diélectrique à la surface des cavités (P) ainsi que du substrat (1) servant de support ;
c) on forme et on structure une couche (E2) conductrice de l'électricité sur la couche (D) diélectrique pour la réalisation d'une pluralité d'électrodes de condensateur au moins dans la pluralité de cavités (P) ;
d) on forme une première sous-couche (2A) isolante sur la surface traitée du substrat (1) servant de support ;
e) on se procure un substrat (3) de composant à semi-conducteur ayant une couche (3S) limite de séparation et une deuxième sous-couche (2B) isolante ;
f) on relie le substrat (3) de composant à semi-conducteur et le substrat (1) servant de support sur leurs sous-couches (2A, 2B) isolantes pour former une couche (2) isolante ; et
g) on sépare une partie du substrat (3) de composant à semi-conducteur sur la couche (3S) limite de séparation.

2. Procédé suivant la revendication 1, **caractérisé en ce qu'**au stade a)
a1) on effectue une attaque électrochimique de pores pour former des pores (P) comme cavités dans un substrat (1) semi-conducteur ; et
a2) on effectue un dopage du substrat (1) semi-conducteur au voisinage des pores (P) pour former une autre couche conductrice de l'électricité en tant que contre-électrode (E1)de condensateur.

3. Procédé suivant la revendication 2, **caractérisé en ce qu'**au stade a2)
a21) on forme un verre de dopage au moins dans les pores (P) ;
a22) on effectue un traitement thermique ; et
a23) on élimine chimiquement en voie humide le verre de dopage.

4. Procédé suivant l'une des revendications 1 à 3, **caractérisé en ce qu'**au stade b) on forme sur toute la surface un diélectrique de condensateur résistant à une température haute et ayant une grande constante diélectrique.

5. Procédé suivant la revendication 4, **caractérisé en ce que** l'on forme de l'oxyde nitruré, de l'Al₂O₃ et/ou du TiO₂ en tant que diélectrique de condensateur.

6. Procédé suivant l'une des revendications 1 à 5, **caractérisé en ce qu'**au stade c)
c1) on forme sur toute la surface une couche (E2) conductrice de l'électricité pour remplir les cavités (P); et
c2) on élimine la couche (E2) conductrice de l'électricité au moins en partie ou complètement jusqu'à la couche (D) diélectrique à la surface du substrat (1) servant de support.

7. Procédé suivant la revendication 6, **caractérisé en ce qu'**au stade c1)
on dépose du polysilicium dopé in situ ; et
au stade c2)
on effectue une structuration photolithographique avec une attaque en retrait anisotrope, de façon à relier entre elles une pluralité d'électrodes de condensateur pour la réalisation d'un condensateur (PK) de groupes.

8. Procédé suivant l'une des revendications 1 à 7, **caractérisé en ce qu'**au stade d) on effectue un procédé de dépôt TEOS.

9. Procédé suivant l'une des revendications 1 à 8, **caractérisé en ce qu'**au stade e) on se procure une tranche (3) semi-conductrice ayant une couche (2B) d'oxyde, la couche (3S) limite de séparation étant formée au moyen d'une implantation d'hydrogène.

10. Procédé suivant l'une des revendications 1 à 9, **caractérisé en ce qu'**au stade f) on effectue une liaison de tranches sur la liaison.

11. Procédé suivant l'une des revendications 1 à 10, **caractérisé en ce qu'**au stade g) on effectue un traitement thermique supplémentaire pour la séparation.

12. Procédé de production d'une cellule de mémoire DRAM dans un substrat semi-conducteur produit suivant les revendications 1 à 11, comprenant les stades dans lesquels :
a) on forme un isolant de sillon plat dans la couche (3) de composant à semi-conducteur pour la réalisation de domaines actifs ;
b) on forme un transistor (AT) de sélection ayant des zones (7) de source/drain, un diélectrique (4) de grille, une couche (5) de commande servant de ligne (WL) de mot et un isolant (6, 8) de grille ;
c) on forme un trou (V) de contact au moins dans la couche (2) isolante et dans la couche (3) de composant à semi-conducteur ;
d) on forme une couche (9) de liaison dans le trou (V) de contact entre une zone (7) de source/drain du transistor (AT) de sélection et au moins une électrode (E2) de condensateur ;
e) on forme une couche (10) isolante intermédiaire ayant un contact (11) de ligne de bit menant à une zone (7) de source/drain complémentaire ; et
f) on forme et on structure une couche (12) de ligne de bit pour la réalisation d'une ligne (BL) de bit à la surface de la couche (10) isolante intermédiaire.

13. Procédé suivant la revendication 12, **caractérisé en ce qu'**au stade c)
en utilisant l'isolant (6, 8) de grille et un procédé lithographique, on dégage à auto-alignement par attaque le trou (V) de contact.

14. Procédé suivant la revendication 12 ou 13, **caractérisé en ce qu'**au stade d)
pour former la couche (9) de liaison on dépose sur toute la surface une couche supplémentaire de semi-conducteur semi-cristallin dopée in situ et on l'attaque en retrait ensuite de façon isotrope ou anisotrope.
